# EUROPEAN PATENT APPLICATION

(11) **EP 2 854 490 A1**
(43) Date of publication of application: **01.04.2015**
(21) Application number: 13185887.0
(22) Date of filing: 25.09.2013
(51) Int. Cl.: H05K 3/00, B05C 3/132, H01L 21/67

(54) **Method and apparatus for a wet-chemical or electrochemical treatment**

(71) Applicant: Atotech Deutschland GmbH, 10553 Berlin (DE)
(72) Inventor: Wiener, Ferdinand, 90559 Burgthann (DE); Thomas, Christian, 91058 Erlangen (DE); Kunze, Henry, 90530 Wendelstein (DE); Mörlein, Felix, 90439 Nürnberg (DE)
(74) Representative: Meier, Florian

(57) **Abstract**

A material (2) is transported through a treatment area (10) along a horizontal transport plane (7) in a transport direction (8). A flow (45) of treatment liquid (9) is generated by a liquid nozzle (21, 31) which ejects the flow (45) of the treatment liquid (9) with a first direction directed towards the treatment area (10). The liquid nozzle (21, 31) is installed at a boundary (13, 14) of the treatment area (10). The liquid nozzle (21, 31) has a first portion (27, 37) facing towards the treatment area (10). The treatment liquid (9) accumulated in the treatment area (10) contacts the first portion (27, 37) of the liquid nozzle (21, 31). A flow (55) of gas is generated by a gas nozzle (22, 32) which is spaced apart from the liquid nozzle (21, 31) along the transport direction (8) by a gap.

## Description

### FIELD OF THE INVENTION

The invention relates to a method and an apparatus for treating a material. The invention relates in particular to a method and apparatus for a wet-chemical or electrochemical treatment of a material having a sensitive surface or a plurality of sensitive surfaces.

### BACKGROUND

The wet-chemical or electrochemical treatment of flat material has wide application in many important industrial fields. For illustration, wet-chemical or electrochemical treatment may be used to process plates having conducting structures, e.g. printed circuit boards, foil made of a conducting material, endless foil-like material, wafers, glass plates, possibly with conducting structures already applies thereon, or a wide variety of other materials.

When processing the material, the material to be treated may be treated in a wet-chemical process line. The material may be exposed to a treatment liquid accumulated in a treatment area. The treatment liquid may be a process chemical or a rinsing liquid, for example. So-called squeeze rollers may be used to hold back the treatment liquid in the treatment area, as disclosed in DE 43 37 988 A1. Traditionally, a pair of squeeze rollers directly contacts both sides of the material throughout the full width of the material. If the material has one or more sensitive surfaces, this direct contact between the squeeze rollers and the material over the entire width of the material may cause damage to the surfaces of the material. Damage to the surfaces of the material may, for example, be caused by the pressure exerted by the squeeze rollers onto the material, by particles adhering to the surfaces of the squeeze rollers or by surface unevenness.

WO 2010/130445 A1 and WO 2010/130444 A1 disclose a treatment apparatus and treatment method which uses gap forming members at boundaries of a treatment area. The gap forming members are positioned such that they do not directly contact the sensitive surface of the material throughout a significant part of the material width.

DE 10 2007 035 086 B3 discloses a treatment apparatus having a treatment area. A sealing area is formed by the interplay of hydrostatic pressure of a treatment liquid accumulated in the treatment area and a gas flow.

### SUMMARY

It is an object of the invention to provide an alternative implementation of a method and an apparatus for a wet-chemical or electrochemical treatment of a material in which the risk of damaging sensitive surfaces of the material may be reduced. It is in particular an object of the invention to provide such a method and apparatus which are suitable for treating a material having a sensitive surface while promoting the exchange of treatment liquid at the sensitive surface of the material.

According to the invention, a method and an apparatus for a wet-chemical or electrochemical treatment of a material as defined by the independent claims are provided. The dependent claims define embodiments.

According to an aspect of the invention, a method for a wet-chemical or electrochemical treatment of a material is provided. The material is transported through a treatment area of a treatment apparatus. The material is transported along a horizontal transport plane in a transport direction. The material is transported in such a manner that the material is transported through a treatment liquid which is accumulated in the treatment area. A flow of the treatment liquid is generated by a liquid nozzle which ejects the flow of the treatment liquid with a first direction directed towards the treatment area. The liquid nozzle is installed at a boundary of the treatment area. A lowest point of the liquid nozzle is located at a first height above the transport plane. The liquid nozzle has a first portion facing towards the treatment area. The treatment liquid accumulated in the treatment area contacts the first portion of the liquid nozzle up to a level located at a height above the transport plane which is greater than the first height. A flow of gas is generated by a gas nozzle. The gas nozzle is spaced apart from the liquid nozzle along the transport direction by a gap. At least a fraction of the gas ejected by the gas nozzle escapes through the gap.

In this method, the combination of liquid nozzle and gas nozzle is operative to remove or hold back treatment liquid from the material. It is not required that squeeze rollers be used which abut on a sensitive surface of the material. The flow of the treatment liquid ejected by the liquid nozzle is operative to reduce outflow of treatment liquid through a clearance between the liquid nozzle and the transport plane. The flow of the treatment liquid ejected by the liquid nozzle also enhances an exchange of the treatment liquid at a surface of the material. The position of the liquid nozzle is set such that the treatment liquid accumulated in the treatment area contacts the first portion of the liquid nozzle. The gap between the gas nozzle and the liquid nozzle allows the gas flow to remove the treatment liquid from the material outside of the treatment area, while providing a space through which the gas may escape without entering into the treatment area.

Throughout this application, a material is referred to as being flat when it has a thickness, measured perpendicular to the transport plane, which is less than both the length and the width of the material measured in the transport plane.

Throughout this application, a liquid flow is referred to as being directed towards the treatment area if a flow vector of the liquid flow has a component parallel to the transport plane and pointing in the direction in which the treatment area is located.

Throughout this application, the term treatment liquid refers to any liquid to which the material may be subjected in an apparatus for electrochemical or wet-chemical treatment. For illustration, the treatment liquid may be a process chemical, a rinsing liquid such as water or the like.

The upper surface of the material may be a sensitive surface. At least a major portion of the upper surface of the material should then not be brought into contact with rigid elements as the material enters or leaves the treatment area.

The liquid nozzle may have a second portion facing away from the treatment area. The treatment liquid may contact the second portion of the liquid nozzle at least up to the first height above the transport plane. The treatment liquid may contact the second portion of the liquid nozzle up to a height which is higher than the first height above the transport plane. Ingress of gas into the treatment area may thereby be prevented in an efficient and simple manner.

The treatment liquid may contact at least one of the first portion or the second portion of the liquid nozzle up to a level which is located at least 1 mm higher above the transport plane than the lowest point of the liquid nozzle. The treatment liquid may contact at least one of the first portion or the second portion of the liquid nozzle up to a level which is located at least 5 mm higher above the transport plane than the lowest point of the liquid nozzle. The treatment liquid may contact at least one of the first portion or the second portion of the liquid nozzle up to a level which is located at least 10 mm higher above the transport plane than the lowest point of the liquid nozzle.

The flow of gas generated by the gas nozzle may push the treatment liquid against the second portion of the liquid nozzle.

A nozzle orifice of the liquid nozzle may be located at a second height above the transport plane which is greater than the first height. The treatment liquid may contact at least one of the first portion or the second portion at least up to the second height. Ingress of gas into the treatment area may thereby be prevented in an efficient and simple manner.

A nozzle orifice of the liquid nozzle may be located at the first height above the transport plane.

The first direction at which the liquid nozzle ejects the liquid flow may enclose an angle of less than 60° with the transport plane. The first direction may be defined by a direction of an orifice channel in the liquid nozzle which opens at the nozzle orifice. The orifice channel of the liquid nozzle may extend along an axis which may enclose an angle of less than 60° with the transport plane. The angle enclosed between the transport plane and the first direction may be at least 10° and at most 45°. The angle enclosed between the transport plane and the first direction may be at least 20° and at most 40°.

The gas nozzle may eject the flow of gas with a second direction different from the first direction. The second direction at which the gas nozzle ejects the flow of gas may enclose a second angle with the transport plane, the second angle being greater than the angle enclosed between the first direction and the transport plane. I.e., the gas flow may be ejected at a greater angle towards the transport plane than the liquid flow.

The second direction may be defined by a direction of an orifice channel in the gas nozzle which opens at a nozzle orifice of the gas nozzle. The orifice channel of the gas nozzle may extend along an axis which may enclose a second angle of at least 30° and at most 90° with the transport plane. The second angle may be included in the interval from at least 60° to at most 90°. The second angle may be included in the interval from at least 80° to at most 90°.

At least one intermediate member may be arranged in the gap between the gas nozzle and the liquid nozzle. The intermediate member may define a clearance between the intermediate member and the material transported below the intermediate member. The gas ejected by the gas nozzle may flow through the clearance towards the liquid nozzle. The intermediate member may be operative as a flow directing device which directs the gas flow along the material towards the liquid nozzle and/or which increases flow speeds close to the surface of the material. This allows treatment liquid to be removed from the material in an efficient manner.

The nozzle arrangement including the gas nozzle and the liquid nozzle as well as, optionally, the intermediate member may be arranged at an entry area or an exit area of the treatment apparatus. In the entry area, the material is transported towards the treatment area. In the exit area, the material is transported away from the treatment area. A nozzle arrangement including the gas nozzle and the liquid nozzle as well as, optionally, the intermediate member may be arranged at the entry area. A further nozzle arrangement including a further gas nozzle, a further liquid nozzle as well as, optionally, a further intermediate member may be arranged at the exit area. The components of the further nozzle arrangement may be configured in the same way as the components of the nozzle arrangement as explained above.

The gap between the gas nozzle and the liquid nozzle may have different lengths, measured along the transport direction, depending on whether the nozzle arrangement is provided at the entry area or the exit area. For illustration, the gap between the gas nozzle and the liquid nozzle at the entry area may have a first length. The gap between the further gas nozzle and the further liquid nozzle at the exit area may have a second length. The second length may be greater than the first length. This allows excess liquid dragged along by the material after leaving the treatment area to be removed efficiently.

The gap length(s) between a gas nozzle and a liquid nozzle may respectively be measured as minimum distances between the surfaces of the gas nozzle and the liquid nozzle which face towards each other.

The first length by which the gas nozzle and the liquid nozzle are spaced apart at the entry area may be at least 5 mm. The second length by which the further gas nozzle and the further liquid nozzle are spaced apart at the exit area may be at least 30 mm.

Different numbers of intermediate members may be provided between the gas nozzle and the liquid nozzle in the entry area and in the exit area. For illustration, at least one intermediate member may be provided between the gas nozzle and the liquid nozzle at the entry area to shape the gas flow. At least two intermediate members may be provided between the further gas nozzle and the further liquid nozzle at the exit area to shape the gas flow. The intermediate member(s) may respectively be formed as rollers which have a cylindrical portion that remains spaced apart from the material and projecting peripheral sections which may abut on the material at a peripheral region thereof. Additional ring-shaped projections of smaller height may be provided on the cylindrical portion.

A treatment member may be positioned in the treatment area. The treatment member may be positioned between the liquid nozzle and the further liquid nozzle. The treatment member may comprise a liquid nozzle. The treatment member may comprise a rotatable roller. A plurality of treatment members may be positioned in the treatment area, i.e., between an entry boundary and an exit boundary of the treatment area.

According to another aspect of the invention, there is provided an apparatus for a wet-chemical or electrochemical treatment of a flat material. The apparatus comprises a treatment area configured to accumulate a treatment liquid. The apparatus comprises a transport device configured to transport the material through the treatment area in a transport direction along a horizontal transport plane such that the material is submerged in the treatment liquid accumulated in the treatment area. The apparatus comprises a liquid nozzle installed at a boundary of the treatment area to generate a flow of the treatment liquid. The liquid nozzle is configured to eject the flow of the treatment liquid with a first direction directed towards the treatment area. The liquid nozzle has a first portion facing towards the treatment area and is installed such that a lowest point of the liquid nozzle is located at a first height above the transport plane. The liquid nozzle is arranged such that, in use of the apparatus, the first portion of the liquid nozzle is brought into contact with the treatment liquid accumulated in the treatment area up to a level located at a height above the transport plane which is greater than the first height. The apparatus further comprises a gas nozzle to generate a flow of gas. The gas nozzle is spaced apart from the liquid nozzle along the transport direction by a gap such that at least a fraction of the gas ejected by the gas nozzle can escape through the gap.

The effects attained by the apparatus correspond to the effects attained by the method. Similarly, additional features of the apparatus which may be used in embodiments and the effects attained thereby correspond to the additional features and effects of the method according to embodiments.

The apparatus may be configured to perform the method of any one aspect or embodiment described herein.

According to another aspect of the invention, there is provided a method of using the apparatus according to an embodiment for treating a flat substrate.

The flat substrate may be selected from a group consisting of: a plate, a plate having conducting structures, a circuit board, a wafer, a glass plate, a flat material having low stiffness, or a foil of a conducting material.

Methods and apparatuses according to embodiments may be used for the wet-chemical or electrochemical treatment of such flat substrates.

### BRIEF DESCRIPTION OF THE DRAWINGS

In the following, embodiments of the invention will be explained in more detail with reference to the attached drawings in which identical or corresponding reference numerals refer to identical or corresponding components.
Figure 1 is a cross-sectional view of an apparatus according to an embodiment.
Figure 2 is a cross-sectional view of an apparatus according to another embodiment.
Figure 3 is a cross-sectional view of a nozzle arrangement of an apparatus according to an embodiment.
Figure 4 is a cross-sectional view of a nozzle arrangement of an apparatus according to another embodiment.
Figure 5 is a cross-sectional view of a nozzle arrangement of an apparatus according to another embodiment.
Figure 6 is a cross-sectional view of a nozzle arrangement of an apparatus according to another embodiment.
Figure 7 is a cross-sectional view of a liquid nozzle of an apparatus according to an embodiment.
Figure 8 is a cross-sectional view of a gas nozzle of an apparatus according to an embodiment.
Figure 9 is a cross-sectional view of a nozzle arrangement of an apparatus according to another embodiment.
Figure 10 is a cross-sectional view of an apparatus according to another embodiment.

### DESCRIPTION OF EMBODIMENTS

Embodiments of methods and apparatuses will be described in detail in which treatment liquid is held off or removed from a material. The material may be a platelike material, e.g. a printed circuit board (PCB) or a glass plate, or a foil-like material having low intrinsic stiffness. In the various embodiments described in the following, the material is transported along a horizontal transport plane. The transport plane is defined by the transport device used in the apparatus for transporting the material. Conventionally, the transport plane is defined to be the plane in which the lower side of the material is located as the material is transported through the apparatus. The upper surface of the material may be a sensitive surface. In other embodiments, both the upper surface and the lower surface of the material may be sensitive surfaces. The methods and apparatuses may be configured such that a sensitive surface may get into contact with a rigid member only at a peripheral edge region.

According to conventional terminology in this field of the art, the terms length or length direction are used to refer to the direction along the transport direction. The terms width or width direction are used to refer to the direction perpendicular to the transport direction, but located in or parallel to the transport plane. The terms height or height direction are used to refer to the direction perpendicular to the transport plane.

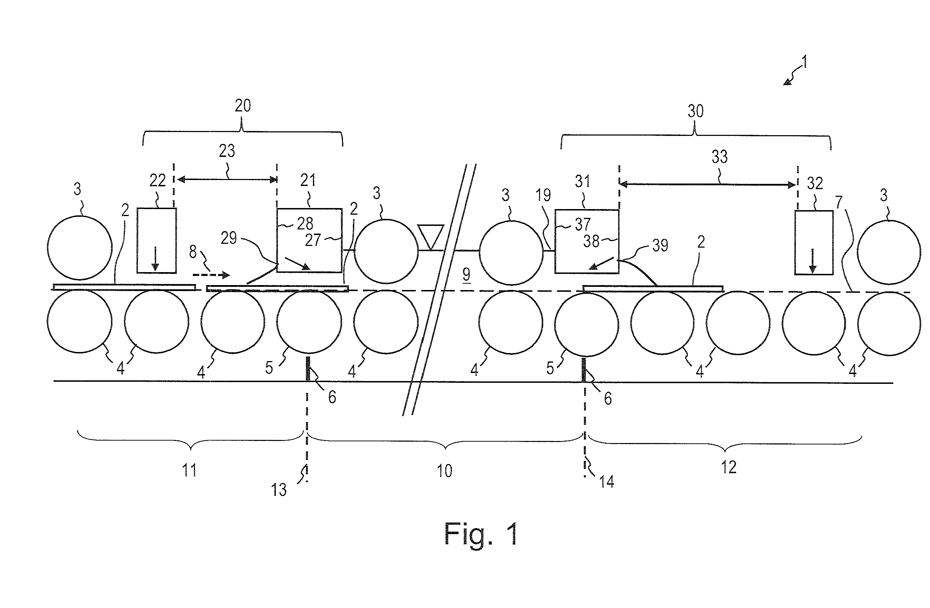

Figure 1 is a cross-sectional view of an apparatus 1 for a wet-chemical or electrochemical treatment of a material 2. The material 2 is a flat material which has a thickness which is smaller, and which may be much smaller, than a length and a width of the material 2. The cross-sectional view of Figure 1 is taken in a plane perpendicular to the transport plane and parallel to the transport direction.

The apparatus 1 generally has a treatment area 10, an entry area 11, and an exit area 12. The material 2 is transported towards the treatment area 10 through the entry area 11. The material 2 enters the treatment area 10 at an entry boundary 13 thereof. As will be explained in more detail below, a liquid nozzle is located at the entry boundary 13. The liquid nozzle ejects a flow of treatment liquid. The resultant liquid flow in a clearance defined between the liquid nozzle and the upper side of the material 2 reduces an outflow of the treatment liquid from the treatment area 10 into the entry area 11.

The material 2 is transported through the treatment area 10 along the transport direction 8. The treatment liquid 9 is accumulated in the treatment area 10 up to a level 19. The level 19 is located at a height above a transport plane 7 which is greater than the thickness of the material 2. The material 2 is immersed in the treatment liquid 9 accumulated in the treatment area 10 while being transported through the treatment area 10. The material 2 exits the treatment area 11 at an exit boundary 14 of the treatment area 10. As will be explained in more detail below, a further liquid nozzle is located at the exit boundary 14. The material 2 is transported through the exit area 12. Treatment liquid is removed from the material 2 while the material 2 is transported through the exit area 12.

The apparatus 2 has a transport device for transporting the material 2 in the transport direction 8. The transport device may include transport rollers 3 located above the transport plane 7 and transport rollers 4 located below the transport plane 7. At least the transport rollers 3 located above the transport plane may respectively have a cylindrical portion which extends across a central region of the material 2 such that the cylindrical portion of the transport rollers 3 remains spaced apart from the upper surface of the material 2. The transport rollers 3 may respectively have projecting sections at the ends thereof which contact peripheral edge portions of the material 2 to transport the material 2. Other implementations of the transport device may be used. For illustration, the material 2 may be supported on support members which may engage chains or belts provided in the apparatus 1.

A liquid weir is respectively provided at the entry boundary 13 and the exit boundary 14 of the treatment area 10. The liquid weir may comprise a wall 6 located below the transport plane. The wall 6 may be fixed. The liquid weir may comprise a roller 5 disposed adjacent the wall 6. The roller 5 may be rotatably mounted and may also take part in transporting the material 2. In other embodiments, the liquid weir may comprise a roller and does not need to comprise the wall 6. Above the transport plane 7, there is respectively provided a nozzle arrangement having a liquid nozzle to reduce an outflow of treatment liquid from the treatment area, as will be explained in more detail below. The amount of treatment liquid dragged by the material 2 into another treatment module may also be reduced.

A nozzle arrangement 20 is provided at a first side of the treatment area 10, e.g. at the entry side relative to the treatment area 10. The nozzle arrangement 20 includes a liquid nozzle 21 and a gas nozzle 22. The liquid nozzle 21 is arranged at the boundary 13 between the treatment area 10 and the entry area 11. The gas nozzle 22 is arranged in the entry area 11 so as to be spaced apart from the boundary 13.

The liquid nozzle 21 ejects a flow of the treatment liquid 9. A nozzle orifice of the liquid nozzle 21 is configured such that the flow of the treatment liquid is ejected towards the treatment area 10. I.e., the velocity field of the ejected flow has a component parallel to the transport plane 7 which points towards the treatment area 10 (i.e., towards the right in Figure 1). The gas nozzle 22 ejects a gas flow. The ejected gas flow establishes a flow field in which at least some of the ejected gas flows towards the liquid nozzle 21. The gas does not pass through a clearance between the liquid nozzle 21 and the transport plane 7, but escapes through a gap between the gas nozzle 22 and the liquid nozzle 21. The gas flow generated by the gas nozzle 22 removes treatment liquid from the material 2 and pushes treatment liquid leaking out from the treatment area 10 back towards the liquid nozzle 21. The clearance between the liquid nozzle 21 and the transport plane 7 may at least partially be filled with the treatment liquid to block the clearance against passage of gas.

The liquid nozzle 21 has a first portion 27 which faces towards the treatment area 10. The liquid nozzle 21 has a second portion 28 which is opposite to the first portion 27 and which faces away from the treatment area 10. The liquid nozzle 21 is arranged such that the treatment liquid 9 accumulated in the treatment area 10 contacts the first portion 27 of the liquid nozzle 21. The treatment liquid 9 may stand against the first portion 27 up to a height which is higher than a first height at which a lowest point of the liquid nozzle 21 is arranged above the transport plane 7.

The treatment liquid may also contact the opposing second portion 28 of the liquid nozzle 21. The gas flow generated by the gas nozzle 22 may push the treatment liquid towards the liquid nozzle 21 such that the treatment liquid stands against the second portion 29 up to a level 29. The level 29 of the treatment liquid at the second portion 28 may be different from, and in particular lower than, the level 19 of the treatment liquid at the first portion 27 of the liquid nozzle 21.

A further nozzle arrangement 30 is provided at the exit side of the treatment area. The further nozzle arrangement 30 includes a further liquid nozzle 31 and a further gas nozzle 32. The configuration and operation of the further liquid nozzle 31 and the further gas nozzle 32 correspond to the configuration and operation explained for the nozzle arrangement 20. The further liquid nozzle 31 ejects a flow of the treatment liquid. A nozzle orifice of the further liquid nozzle 31 is configured such that the flow of the treatment liquid is ejected towards the treatment area 10. i.e., the velocity field of the ejected flow has a component parallel to the transport plane 7 which points towards the treatment area 10 (i.e., towards the left in Figure 1). The liquid nozzle 21 and the further liquid nozzle 31 may be mirror-symmetrical to one another, so as to ensure that both liquid nozzles eject a flow of the treatment liquid which is respectively directed towards the treatment area 10. The further liquid nozzle 31 may have a first portion 37 which faces towards the treatment area 10. The further liquid nozzle 21 may have a second portion 38 which is opposite to the first portion 37 and which faces away from the treatment area 10. The further liquid nozzle 31 is arranged such that the treatment liquid 9 accumulated in the treatment area 10 contacts the first portion 27 of the liquid nozzle 21. The treatment liquid may contact both the first portion 37 and the second portion 38 of the further liquid nozzle 31, analogously to the situation at the liquid nozzle 21.

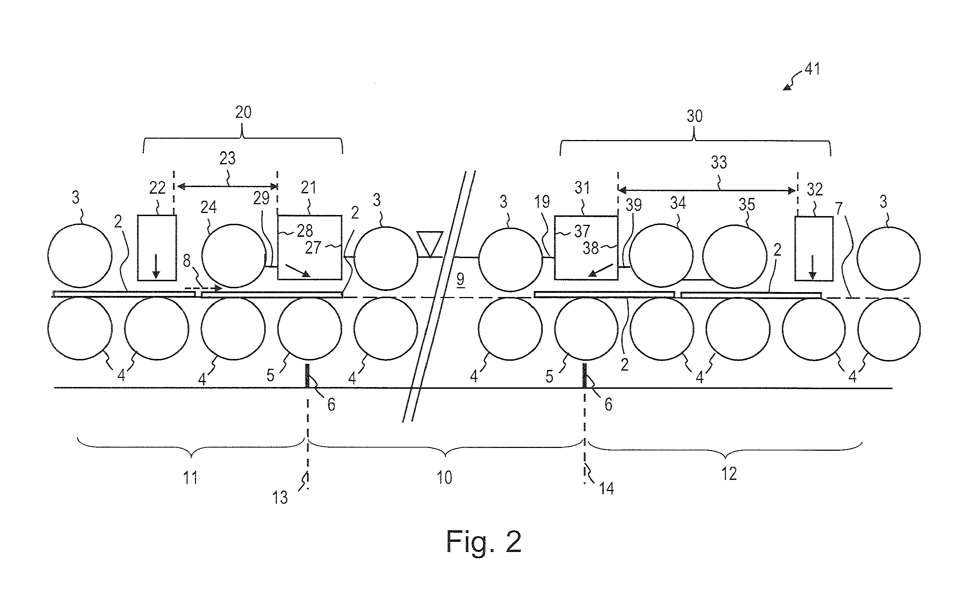

While the nozzle arrangement 20 at the entry side and the further nozzle arrangement 30 at the exit side may have generally similar configurations, the gaps between the liquid nozzle and the gas nozzle may be different. For illustration, the liquid nozzle 21 and the gas nozzle 22 are separated by a gap. The gap has a first length 23 measured along the transport direction 8. The further liquid nozzle 31 and the further gas nozzle 32 are separated by a further gap. The further gap has a second length 33 measured along the transport direction 8. The second length 33 may be greater than the first length 32. The first length 31 may be at least 5 mm. The second length 33 may be at least 30 mm. As will be described in more detail with reference to Fig. 2, one or several intermediate member(s) may respectively be arranged in the gap between the liquid nozzle and the gas nozzle.

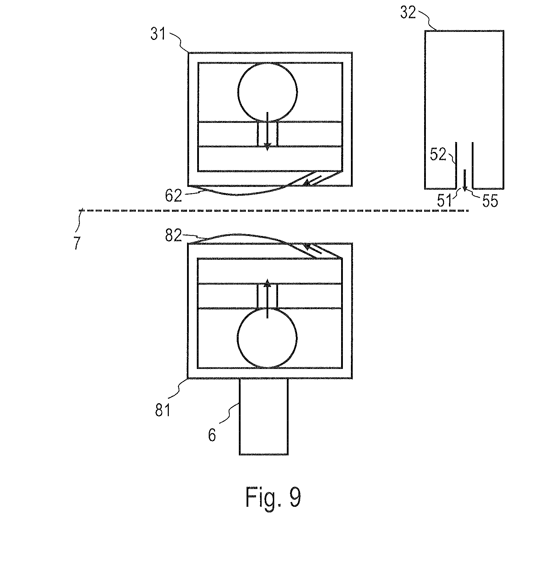

In the apparatus 1, a liquid nozzle 21 is provided at the entry boundary 13 between the treatment area 10 and the entry area 11 only above the transport plane 7. Below the liquid nozzle 21, there is provided a liquid weir which does not include another liquid nozzle. This similarly applies to the liquid nozzle 31 at the exit boundary 14 between the treatment area 10 and the exit area 12. In other embodiments, a pair of liquid nozzles may be installed on opposite sides of the transport plane 7 at at least one of the boundaries 13 and 14, as will be explained with reference to Fig. 9.

Figure 2 is a cross-sectional view of an apparatus 41 for a wet-chemical or electrochemical treatment of a material 2. The cross-sectional view of Figure 2 is taken in a plane perpendicular to the transport plane 7 and parallel to the transport direction 8.

In the apparatus 41, the nozzle arrangement 20 provided at the entry side of the treatment area 10 includes an intermediate member 24. The intermediate member 24 is installed in the gap between the liquid nozzle 21 and the gas nozzle 22. The intermediate member 24 is arranged above the transport plane 7 and defines a clearance between the intermediate member 24 and the material 2 when the material passes below the intermediate member. The intermediate member 24 may perform flow shaping for the gas flow. The intermediate member 24 defines a constriction in a channel through which gas may flow from the gas nozzle 22 to the liquid nozzle 21. The intermediate member 24 may define a tapering channel which directs gas ejected by the gas nozzle 22 along the upper side of the material 2. As shown in Figure 2, only one intermediate member 24 may be installed in the gap between the liquid nozzle 21 and the gas nozzle 22.

The nozzle arrangement 30 provided at the downstream side of the treatment area 10 includes plural intermediate members 34, 35. The intermediate members 34, 35 are installed in the gap between the further liquid nozzle 31 and the further gas nozzle 32. The intermediate members 34, 35 are arranged above the transport plane 7 and respectively define a clearance between the intermediate members 34, 35 and the material 2 when the material passes below the intermediate members 34, 35. The intermediate members 34, 35 may perform flow shaping for the gas flow. The intermediate members 34, 35 define a constriction in a channel through which gas may flow from the further gas nozzle 32 to the further liquid nozzle 31. The intermediate members 34, 35 may define a tapering channel which directs gas ejected by the further gas nozzle 32 along the upper side of the material 2. As shown in Figure 2, only two intermediate members 34, 35 may be installed in the gap between the further liquid nozzle 31 and the further gas nozzle 32.

One or several of the intermediate members 24, 34, 35 may be configured as a roller. However, it is not required for the intermediate members 24, 34, 35 to be rotatably mounted. For illustration, at least one or all of the intermediate members 24, 34, 35 may be mounted such that they are not rotatable about an axis transverse to the transport direction.

The intermediate member(s) 24, 34, 35 may respectively have a cylindrical shape on at least a portion of their outer surface. Other surface configurations may be used for directing the gas flow towards the liquid nozzle along the upper side of the material 2.

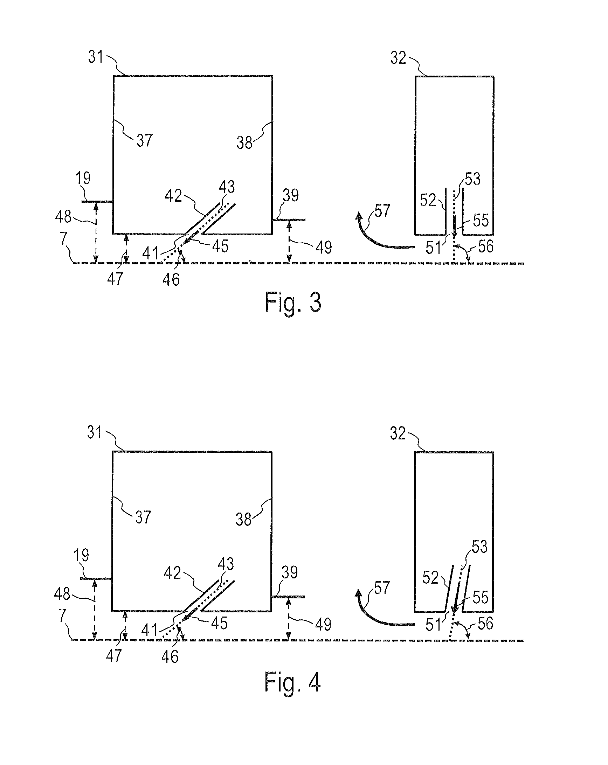

Figures 3 to 6 respectively show an enlarged cross-sectional view of a nozzle arrangement which may be used in apparatuses and method according to embodiments. While the nozzle arrangement is shown for only one of the two sides of the treatment area, the nozzle arrangement on the opposite side may have a corresponding configuration. One or several intermediate member(s) may be installed in the gap between the gas nozzle and the liquid nozzle, as illustrated in Figure 2.

The liquid nozzle 31 has a nozzle orifice 41 through which the treatment liquid is ejected. An orifice channel 42 may supply the treatment liquid to the nozzle orifice 41. The orifice channel 42 may extend along an axis 43. A flow 45 of the treatment liquid ejected by the liquid nozzle has a first direction. The first direction may correspond to the axis 43 along which the orifice channel 42 extends.

Similarly, the gas nozzle 32 has a nozzle orifice 51 through which gas is ejected. An orifice channel 52 may supply the gas to the nozzle orifice 51. The orifice channel 52 may extend along an axis 53. A flow 55 of the gas ejected by the liquid nozzle has a second direction. The second direction may correspond to the axis 53 along which the orifice channel 52 extends.

Figure 3 shows a configuration of the nozzle arrangement in which the nozzle orifice 41 of the liquid nozzle 31 is located at a point of the liquid nozzle 31 which is closest to the transport plane 7. The point of the liquid nozzle which is closest to the transport plane 7 is located at a first height 47 above the transport plane. In the configuration illustrated in Figure 3, the nozzle orifice 41 is located at a distance from the transport plane which is equal to the first height 47.

To reduce or prevent ingress of gas into the treatment area through the clearance below the liquid nozzle 31, the treatment liquid may contact both the first portion 37 and the second portion 38 of the liquid nozzle 31. The treatment liquid may contact the first portion 37 which faces towards the treatment area up to a level 19 which lies at a height 48 above the transport plane 7. The treatment liquid may contact the second portion 38 which faces away from the treatment area up to a level 39 which lies at a height 49 above the transport plane 7. Both the height 48 and the height 49 may be greater than the first height 47 at which the lowest point of the liquid nozzle 31 is arranged above the transport plane 7. At least one of the levels 19 and 39 may be located at a height which is at least 1 mm higher, in particular at least 5 mm higher, in particular at least 10 mm higher than the first height 47 at which the lowest point of the liquid nozzle 31 is located above the transport plane 7.

The liquid nozzle 31 ejects the flow 45 of the treatment liquid with a first direction. The first direction has a component parallel to the transport direction which points towards the treatment area. The first direction may enclose an angle 46 with the transport plane 7. The angle 46 may be less than 60°. The angle 46 may be at least 10° and at most 45°. The angle 46 may be at least 20° and at most 40°.

The gas nozzle 32 ejects the gas flow 55 with a second direction. The second direction may be different from the first direction. The second direction may enclose a second angle 56 with the transport plane 7. The second angle 56 may be greater than the angle 46. The second angle may be greater than 30°. The second angle 56 may be at least 60° and at most 90°. The second angle 56 may be at least 80° and at most 90°. By selecting the second angle 56 such that the gas flow is ejected at a steeper angle towards the transport plane 7 than the liquid flow, the ejected gas is less likely to enter the treatment area below the liquid nozzle 31. A fraction 57 of the ejected gas may escape through the gap between the liquid nozzle 31 and the gas nozzle 32 in an upward direction. The gas flow generated by the gas nozzle, optionally in combination with the intermediate member(s) disposed in the gap between the liquid nozzle 31 and the gas nozzle 32, also removes the treatment liquid from the material 2.

Figure 4 shows another configuration of the nozzle arrangement. The gas nozzle 32 ejects the gas flow 55 with the second direction which is angled relative to a normal vector of the transport plane 7.

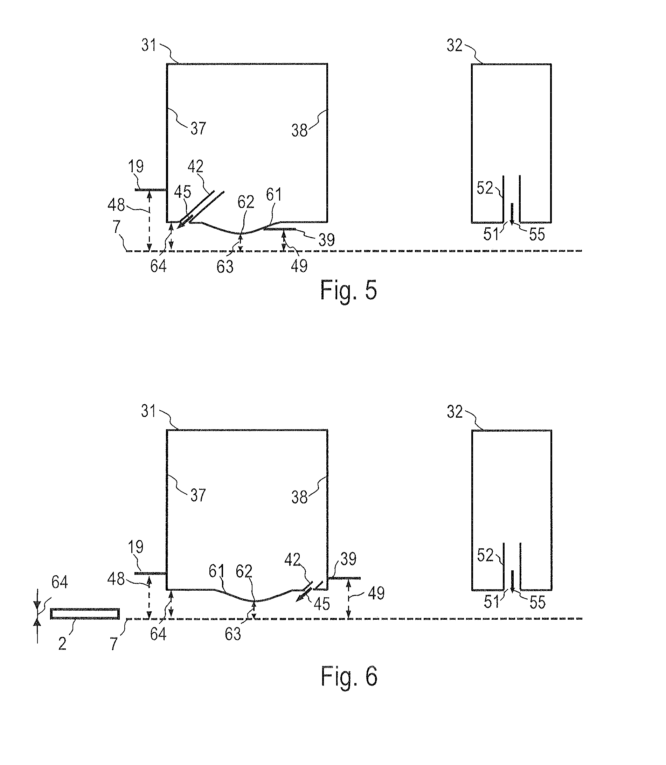

The liquid nozzle 31 may have more complicated configurations. In particular, the nozzle orifice of the liquid nozzle does not need to be located at the point of the liquid nozzle 31 which is closest to the transport plane 7. The nozzle orifice 41 of the liquid nozzle 31 may be offset from the point of the nozzle closest to the transport plane, either in a direction towards the treatment area or away from the treatment area. This will be explained in more detail with reference to Figure 5 and Figure 6.

Figure 5 shows another configuration of the nozzle arrangement. The liquid nozzle 31 has a bulged portion 61. A lower apex 62 on the bulged portion 61 is located closest to the transport plane 7. The lower apex 62 is located at a first height 63 above the transport plane 7. The nozzle orifice 41 of the liquid nozzle 31 is offset from the lower apex 62 towards the treatment area. The nozzle orifice 41 is located at a second height 64 above the transport plane 7. The second height 64 is greater than the first height 63.

The treatment liquid may contact the first portion 37 which faces towards the treatment area up to a level 19 which lies at a height 48 above the transport plane 7. The height 48 is greater than the second height 64. This ensures that the nozzle orifice 41 is submerged in the treatment liquid.

The treatment liquid may also contact the second portion 38 of the liquid nozzle 31 which faces away from the treatment area. The treatment liquid may contact the second portion 38 up to a level 39 which lies at a height 49 above the transport plane 7. The height 49 is greater than the first height 63. The height 49 may be less than the second height 64 at which the nozzle orifice 41 is located above the transport plane 7. Ingress of gas into the treatment area through the clearance below the nozzle orifice 31 is thereby suppressed.

Figure 6 shows another configuration of the nozzle arrangement. The liquid nozzle 31 has the bulged portion 61 with the lower apex 62 being located closest to the transport plane 7. The nozzle orifice 41 of the liquid nozzle 31 is offset from the lower apex 62 in a direction away from the treatment area. The nozzle orifice 41 is located at a second height 64 above the transport plane 7. The second height 64 is greater than the first height 63.

The treatment liquid may contact the first portion 37 which faces towards the treatment area up to a level 19 which lies at a height 48 above the transport plane 7. The height 48 is greater than the first height 63 at which the lower apex 62 is located. Ingress of gas into the treatment area through the clearance below the nozzle orifice 31 is thereby suppressed.

The treatment liquid may also contact the second portion 38 of the liquid nozzle 31 which faces away from the treatment area. The treatment liquid may contact the second portion 38 up to a level 39 which lies at a height 49 above the transport plane 7. The height 49 is greater than the second height 64 at which the nozzle orifice 41 is located. This ensures that the nozzle orifice 41 is submerged in the treatment liquid.

Generally, as illustrated in Figure 5 and Figure 6, the nozzle orifice of the liquid nozzle may be offset from the point(s) of the liquid nozzle which is or are closest to the transport plane. If the nozzle orifice is offset towards the treatment area, the level of the treatment liquid at the first portion 37 may be higher than the second height 64 at which the nozzle orifice 41 is located. If the nozzle orifice is offset from the lower apex 62 towards the treatment area, the level of the treatment liquid at the second portion 38 may be higher than the first height 63 at which the point closest to the transport plane is arranged. If the nozzle orifice is offset from the lower apex 62 in a direction away from the treatment area, the level of the treatment liquid at the first portion 37 may be higher than the first height 63 at which the point closest to the transport plane is arranged. If the nozzle orifice is offset from the lower apex 62 in the direction away from the treatment area, the level of the treatment liquid at the second portion 38 may be higher than the second height 64 at which the nozzle orifice 41 is located.

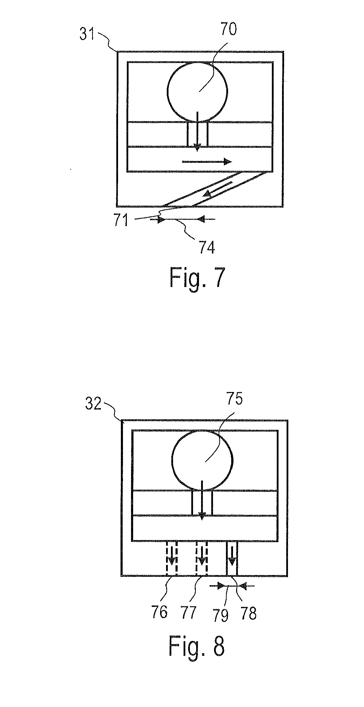

Various implementations of the liquid nozzle and the gas nozzle may be realized, as illustrated in Figure 7 and Figure 8.

Figure 7 shows a cross-sectional view through a liquid nozzle 31. The treatment liquid is supplied through a supply channel 70. A nozzle orifice 71 may be configured as a slot-shaped nozzle orifice which extends in a direction transverse to the transport direction.

Figure 8 shows a cross-sectional view through a gas nozzle 32. The gas is supplied through a supply channel 75. A nozzle array with nozzle orifices 76-78 is provided. The nozzle-orifices 76-78 may be circular, for example. The nozzle orifices 76-78 may be offset from each other both in the transport direction and in the width direction perpendicular to the transport direction. I.e., the nozzle orifices 76, 77 may be located at other positions in the width direction than the nozzle orifice 78.

In the nozzle configurations of Figure 7 and of Figure 8, a width 74, 79 of the nozzle orifice measured parallel to the transport direction may be between 0.1 and 5 mm. The width 74, 79 may be included in the interval from 0.2 to 2 mm. The width 74, 79 may be included in the interval from 0.3 to 1.5 mm.

In any one of the embodiments, the liquid nozzle may be configured such that it ejects the flow of the treatment liquid with a velocity which is at least 0.5 m/s and at most 10 m/s at the nozzle orifice. The gas nozzle may be configured such that it ejects the gas flow with a velocity which is at least 5 m/s and at most 50 m/s at the nozzle orifice.

While a liquid nozzle having a slot-shaped nozzle orifice 71 is illustrated in Figure 7, the liquid nozzle may also have an orifice array with plural separate nozzle orifices as explained with reference to Figure 8. Similarly, while a gas nozzle having an orifice array 72-74 is illustrated in Figure 8, the gas nozzle may also have a slot-shaped nozzle orifice as explained with reference to Figure 7.

In the embodiments explained with reference to Figure 1 to Figure 8, a liquid weir comprising a roller is arranged below the liquid nozzle at the boundary of the treatment area. In still other embodiments, a pair of liquid nozzles arranged on opposite sides of the transport plane may be provided at the exit boundary and/or at the entry boundary of the treatment area.

Figure 9 shows a nozzle arrangement which may be used in the entry area 11 or an exit area 12 of a treatment apparatus. The nozzle arrangement includes a liquid nozzle 31 and a gas nozzle 32 arranged above the transport plane 7. Below the liquid nozzle 31, there is provided a second liquid nozzle 81 which is installed below the transport plane 7. The second liquid nozzle 81 ejects a second flow of the treatment liquid. The second flow is also directed towards the treatment area. I.e., a flow velocity at a nozzle orifice of the second liquid nozzle 81 has a component which is directed towards the treatment area in which the treatment liquid is accumulated.

In the nozzle arrangement of Figure 9, the liquid nozzle 31 and the second liquid nozzle 81 respectively have a bulged portion 62, 82. The bulged portions 62, 82 face towards each other. The bulged portions 62, 82 are convex. The bulged portions 62, 82 define a tapering channel, thereby decreasing the cross-sectional area of the clearance between the liquid nozzle 31 and the second liquid nozzle 81. The reduced cross-sectional area may reduce the outflow of treatment liquid from the treatment area.

A configuration in which a liquid nozzle 31 or a pair of liquid nozzles 31, 81 respectively have a convex, bulged portion 62, 82 may be particularly useful for processing stations of a process line in which the treatment area only holds a moderate or small amount of the treatment liquid. For illustration, in a rinsing station, the amount of rinsing liquid may frequently be smaller than the amount of process liquid used in other processing stations of the process line. A configuration with a liquid nozzle 31 or a pair of liquid nozzles 31, 81 which respectively have a convex portion, as shown in Figures 5, 6 and 9, may be used at the boundaries of the treatment area in a rinsing station.

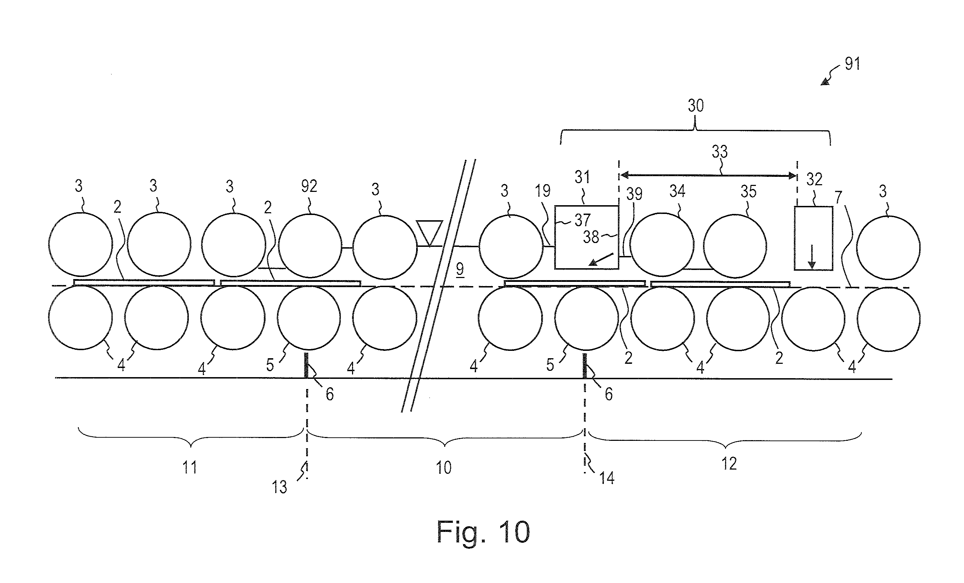

Nozzle arrangements having a liquid nozzle and a gas nozzle may be used at both boundaries of the treatment area, as illustrated in Figure 1 and Figure 2. In other embodiments, a nozzle arrangement having a liquid nozzle and a gas nozzle may be used only at the entry boundary or only at the exit boundary of the treatment area. At the opposite boundary, there may be provided a gap-forming member which holds the treatment liquid off the material. This is illustrated in Figure 10.

Figure 10 shows an apparatus 91 according to another embodiment. A nozzle arrangement 30 is provided, with the liquid nozzle 31 installed at the exit boundary 14 of the treatment area 10.

At the opposite exit boundary 14 of the treatment area 10, there is installed a gap forming member 92 to hold the treatment liquid off from the material 2. The gap forming member 92 may be configured such that it contacts the material 2 only at its peripheral edge portions which extend parallel to the transport direction. The gap forming member 92 may be rotationally mounted. The gap forming member 92 may have a cylindrical portion, with projecting sections formed at the lateral sides of the cylindrical portion to contact the peripheral edge portions of the material 2.

In other embodiments, the nozzle arrangement having the liquid nozzle and the gas nozzle may be installed only at the entry boundary 13 of the treatment area. A gap forming member 92 may then be installed at the exit boundary 14.

Methods and apparatuses according to embodiments of the invention are operative to hold the treatment liquid in the treatment area by reducing the outflow of treatment liquid at the boundaries of the treatment area. The nozzle arrangement also removes treatment liquid from the material after the material has left the treatment area.

Methods and apparatuses according to embodiments may be used for treating plate-shaped material, e.g. plates having conducting structures thereon, in particular printed circuit boards (PCBs), wafers, glass plates, foils, or an endless foil-like material, without being limited thereto. The methods and apparatuses according to embodiments may be used for treating one side or for treating both sides of the material.

### LIST OF REFERENCE NUMERALS

- 1: treatment apparatus
- 2: flat material
- 3, 4: transport rollers
- 5, 6: liquid weir
- 7: transport plane
- 8: transport direction
- 9: treatment liquid
- 10: treatment area
- 11: entry area
- 12: exit area
- 13, 14: boundary of treatment area
- 19: level in treatment area
- 20: nozzle arrangement
- 21: liquid nozzle
- 22: gas nozzle
- 23: gap
- 24: intermediate member
- 27: first portion
- 28: second portion
- 29: outer level
- 31: liquid nozzle
- 32: gas nozzle
- 33: gap
- 34, 35: intermediate member
- 37: first portion
- 38: second portion
- 39: level
- 41: nozzle orifice
- 42: orifice channel
- 43: first direction
- 45: ejected liquid flow
- 46: angle
- 47-49: height above transport plane
- 51: nozzle orifice
- 52: orifice channel
- 53: second direction
- 55: ejected gas flow
- 56: second angle
- 57: portion of gas flow
- 61: bulged portion
- 62: lower apex
- 63: height above transport plane
- 64: thickness
- 70: liquid supply channel
- 71: slot-shaped nozzle orifice
- 74: width of nozzle orifice
- 75: gas supply channel
- 76-78: orifice array
- 79: width of nozzle orifice
- 81: liquid nozzle
- 82: bulged portions
- 91: treatment apparatus
- 92: squeeze roller

## Claims

1. A method for a wet-chemical or electrochemical treatment of a flat material (2), the method comprising:
transporting the material (2) through a treatment area (10) along a horizontal transport plane (7) in a transport direction (8) such that the material (2) is transported through a treatment liquid (9) which is accumulated in the treatment area (10),
generating a flow (45) of the treatment liquid (9) by a liquid nozzle (21, 31) which ejects the flow (45) of the treatment liquid (9) with a first direction directed towards the treatment area (10), wherein the liquid nozzle (21, 31) is installed at a boundary (13, 14) of the treatment area (10) with a lowest point (41; 62) of the liquid nozzle (21, 31) being located at a first height (47; 62) above the transport plane (7), wherein the liquid nozzle (21, 31) has a first portion (27, 37) facing towards the treatment area (10) and the treatment liquid (9) accumulated in the treatment area (10) contacts the first portion (27, 37) of the liquid nozzle (21, 31) up to a level (19) located at a height (48) above the transport plane (7) which is greater than the first height (47; 62), and
generating a flow (55) of gas by a gas nozzle (22, 32) which is spaced apart from the liquid nozzle (21, 31) along the transport direction (8) by a gap such that at least a fraction (57) of the gas ejected by the gas nozzle (22, 32) escapes through the gap.

2. The method of claim 1,
wherein the liquid nozzle (21, 31) has a second portion (28, 38) facing away from the treatment area (10), wherein the treatment liquid (9) contacts the second portion (28, 38) of the liquid nozzle (21, 31) at least up to the first height (47; 62) above the transport plane (7).

3. The method of claim 2,
wherein the flow (55) of gas generated by the gas nozzle (22, 32) pushes the treatment liquid (9) against the second portion (28, 38) of the liquid nozzle (21, 31).

4. The method of any one of the preceding claims,
wherein the first direction at which the liquid nozzle (21, 31) ejects the liquid flow encloses an angle (46) of less than 60° with the transport plane (7).

5. The method of any one of the preceding claims,
wherein the gas nozzle (22, 32) ejects the flow (55) of gas with a second direction different from the first direction.

6. The method of claim 5,
wherein the second direction at which the gas nozzle (22, 32) ejects the flow (55) of gas encloses a second angle (56) with the transport plane (7), the second angle (56) being greater than an angle (46) enclosed between the first direction and the transport plane (7).

7. The method of any one of the preceding claims,
wherein at least one intermediate member (24, 34, 35) is arranged in the gap between the gas nozzle (22, 32) and the liquid nozzle (21, 31), the intermediate member (24, 34, 35) defining a clearance between the intermediate member (24, 34, 35) and the material (2), wherein gas ejected by the gas nozzle (22, 32) flows through the clearance towards the liquid nozzle (21, 31).

8. The method of any one of the preceding claims,
wherein the liquid nozzle (21) and the gas nozzle (22) are arranged at a first side (11) of the treatment area (10), and
wherein a further liquid nozzle (31) and a further gas nozzle (32) are arranged at a second side (12) of the treatment area (10) opposite to the first side (11), the further gas nozzle (32) being spaced apart from the further liquid nozzle (31) by a further gap which has a greater length (33) than the gap between the gas nozzle (22, 32) and the liquid nozzle (21, 31).

9. The method of any one of the preceding claims,
wherein a liquid weir (6) is installed at the boundary (13, 14) of the treatment area (10) below the liquid nozzle (21, 31), the liquid weir (6) being arranged below the transport plane (7).

10. An apparatus for a wet-chemical or electrochemical treatment of a flat material (2), the apparatus comprising:
a treatment area (10) configured to accumulate a treatment liquid (9),
a transport device (3, 4) configured to transport the material (2) through the treatment area (10) in a transport direction (8) along a horizontal transport plane (7) such that the material (2) is submerged in the treatment liquid (9) accumulated in the treatment area (10),
a liquid nozzle (21, 31) installed at a boundary (13, 14) of the treatment area (10) to generate a flow (45) of the treatment liquid (9), the liquid nozzle (21, 31) being configured to eject the flow (45) of the treatment liquid (9) with a first direction directed towards the treatment area (10), wherein the liquid nozzle (21, 31) has a first portion (27, 37) facing towards the treatment area (10), wherein the liquid nozzle (21, 31) is installed such that a lowest point (41; 62) of the liquid nozzle (21, 31) is located at a first height (47; 62) above the transport plane (7) and that the first portion (27, 37) of the liquid nozzle (21, 31) is brought into contact with the treatment liquid (9) accumulated in the treatment area (10) up to a level (19) located at a height (48) above the transport plane (7) which is greater than the first height (47; 62), and
a gas nozzle (22, 32) to generate a flow (55) of gas, the gas nozzle (22, 32) being spaced apart from the liquid nozzle (21, 31) along the transport direction (8) by a gap to allow at least a fraction (57) of the gas ejected by the gas nozzle (22, 32) to escape through the gap.

11. The apparatus of claim 10,
wherein the liquid nozzle (21, 31) has a second portion (28, 38) facing away from the treatment area (10), wherein the treatment liquid contacts the second portion (28, 38) of the liquid nozzle (21, 31) at least up to the first height (47; 62) above the transport plane (7).

12. The apparatus of claim 11,
wherein the flow (55) of gas generated by the gas nozzle (22, 32) pushes the treatment liquid against the second portion (28, 38) of the liquid nozzle (21, 31).

13. The apparatus of any one of claims 10 to 12, further comprising at least one intermediate member (24, 34, 35) arranged in the gap between the gas nozzle (22, 32) and the liquid nozzle (21, 31), the intermediate member (24, 34, 35) defining a clearance between the intermediate member (24, 34, 35) and the material (2) to allow gas ejected by the gas nozzle (22, 32) to flow through the clearance towards the liquid nozzle (21, 31).

14. The apparatus of any one of claims 10 to 13,
wherein the liquid nozzle (21) and the gas nozzle (22) are arranged at a first side (11) of the treatment area (10), and
wherein the apparatus comprises a further liquid nozzle (31) and a further gas nozzle (32) arranged at a second side (12) of the treatment area (10) opposite to the first side (11), the further gas nozzle (32) being spaced apart from the further liquid nozzle (31) by a further gap which has a greater length (33) than the gap between the gas nozzle (22) and the liquid nozzle (21).

15. Use of the apparatus (1; 41; 91) of any one of claims 10 to 14 for treating a flat substrate.
